# EUROPEAN PATENT APPLICATION

(11) **EP 3 960 988 A1**
(43) Date of publication of application: **02.03.2022**
(21) Application number: 21189534.7
(22) Date of filing: 03.08.2021
(51) Int. Cl.: F01D 5/14, F01D 1/34, F02C 7/277

(54) **TURBINE AIRFOIL DESIGN**

(30) Priority: 13.08.2020 US 202016992743
(71) Applicant: Honeywell International Inc., Charlotte, NC 28202 (US)
(72) Inventor: CONNER, Richard, Charlotte, 28202 (US); REYNOLDS, Bruce, Charlotte, 28202 (US)
(74) Representative: LKGlobal UK Ltd.

(57) **Abstract**

In an exemplary embodiment, a method for manufacturing turbine wheel airfoils includes: defining an initial design with an initial respective line for a straight line cut for a respective surface of each airfoil; evaluating an initial score for the initial design based on mechanical, aerodynamic, manufacturing cost, and robustness criteria; performing, in an iterative manner, a sequence of changes to the initial design, by adjusting the initial respective line for the straight line cut for the respective surface of each airfoil to generate different iterative designs; evaluating respective scores for each of the different iterative designs; selecting a design from the initial design and the different iterative designs that generates an optimized score based on the mechanical, aerodynamic, manufacturing cost, and robustness criteria; and cutting along the straight line for the surface of each airfoil, based on the selected design, to form each airfoil.

## Description

### INTRODUCTION

The technical field generally relates to the field of air turbine starters and, more specifically, to design of turbine airfoils for air turbine starters, for example for turbine engines for aircraft, and other applications.

Many air turbine starters today, including for turbine engines for aircraft and various other applications, include turbine airfoils. However, present designs for turbine airfoils may not always provide optimal for optimal manufacturing in certain conditions.

Accordingly, it is desirable to provide methods and systems for designing turbine airfoils for air turbine starters, for example for turbine engines for aircraft and/or other vehicles, and/or for other applications. Furthermore, other desirable features and characteristics of the present invention will become apparent from the subsequent detailed description of the invention and the appended claims, taken in conjunction with the accompanying drawings and this background of the invention.

### SUMMARY

In an exemplary embodiment, a method for manufacturing a plurality of airfoils for a turbine wheel includes the steps of: defining an initial design comprising an initial respective line for a straight line cut for a respective surface of each airfoil of the plurality of airfoils; evaluating an initial score for the initial design based on mechanical, aerodynamic, manufacturing cost, and robustness criteria; performing, in an iterative manner, a sequence of changes to the initial design, by adjusting the initial respective line for the straight line cut for the respective surface of each of the plurality of airfoils to generate different iterative designs; evaluating respective scores for each of the different iterative designs; selecting a design from the initial design and the different iterative designs that generates an optimized score based on the mechanical, aerodynamic, manufacturing cost, and robustness criteria; and cutting along the straight line for the surface of each of the plurality of airfoils based on the selected design, to form each of the plurality of airfoils.

In another exemplary embodiment, a method for determining a design for manufacturing of a plurality of airfoils for a turbine wheel, the method includes the steps of: defining, via a processor, a plurality of potential designs for a straight line cut for a respective surface of each airfoil of the plurality of airfoils; performing, via instructions provided by the processor, a test of each of the potential designs; calculating, via the processor, a respective score for each of the potential designs, based on the testing, and based on mechanical, aerodynamic, manufacturing cost, and robustness criteria; and selecting, via the processor, a design from the potential designs that generates an optimized score based on the mechanical, aerodynamic, manufacturing cost, and robustness criteria.

In a further exemplary embodiment, a computer system for determining a design for manufacturing of a plurality of airfoils for a turbine wheel, the computer system including a non-transitory computer readable storage medium and a processor. The non-transitory computer readable storage medium is configured to store data pertaining to a plurality of potential designs for a straight line cut for a respective surface of each airfoil of the plurality of airfoils. The processor is coupled to the non-transitory computer readable storage medium, and is configured to: provide instructions for performing a test of each of the potential designs; calculate a respective score for each of the potential designs, based on the testing, and based on mechanical, aerodynamic, manufacturing cost, and robustness criteria; and select a design from the potential designs that generates an optimized score based on the mechanical, aerodynamic, manufacturing cost, and robustness criteria.

Furthermore, other desirable features and characteristics of the system and method will become apparent from the subsequent detailed description and the appended claims, taken in conjunction with the accompanying drawings and the preceding background.

### DESCRIPTION OF THE DRAWINGS

The present disclosure will hereinafter be described in conjunction with the following drawing figures, wherein like numerals denote like elements, and wherein:
FIG. 1 is a simplified cross section representation of an exemplary air turbine starter that includes a turbine rotor component, and for example that may be implemented in a turbine engine for an aircraft and/or other vehicle, and/or for one or more various other applications, in accordance with an exemplary embodiment;
FIGS. 2A and 2B depict partial views of a turbine rotor component that may be used in the turbine starter of FIG. 1, in accordance with an exemplary embodiment;
FIG. 3 is a flowchart of a process that may be used to design and manufacture airfoils of the turbine rotor component of FIGS. 2A and 2B, in accordance with an exemplary embodiment;
FIGS. 4A and 4B depict views of surfaces of the turbine rotor component of FIGS. 2A and 2B, depicted with straight line element (SLE) lines illustrated on a representative blade of each of the surfaces for manufacturing in accordance with the process of FIG. 3, in accordance with an exemplary embodiment; and
FIG. 5 is a functional block diagram of a system for designing and manufacturing turbine airfoils in accordance with the process of FIG. 3, in accordance with an exemplary embodiment.

### DETAILED DESCRIPTION

The following detailed description is merely exemplary in nature and is not intended to limit the disclosure or the application and uses thereof. Furthermore, there is no intention to be bound by any theory presented in the preceding background or the following detailed description.

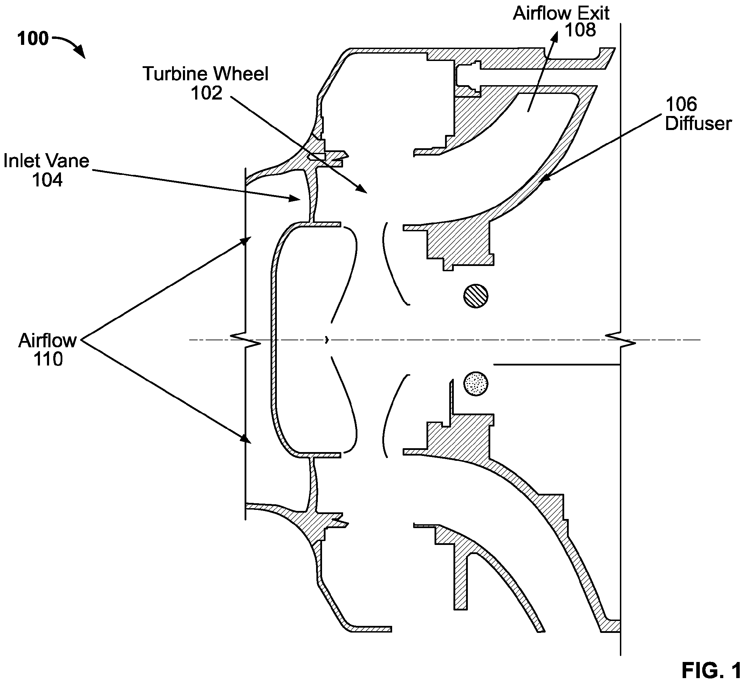

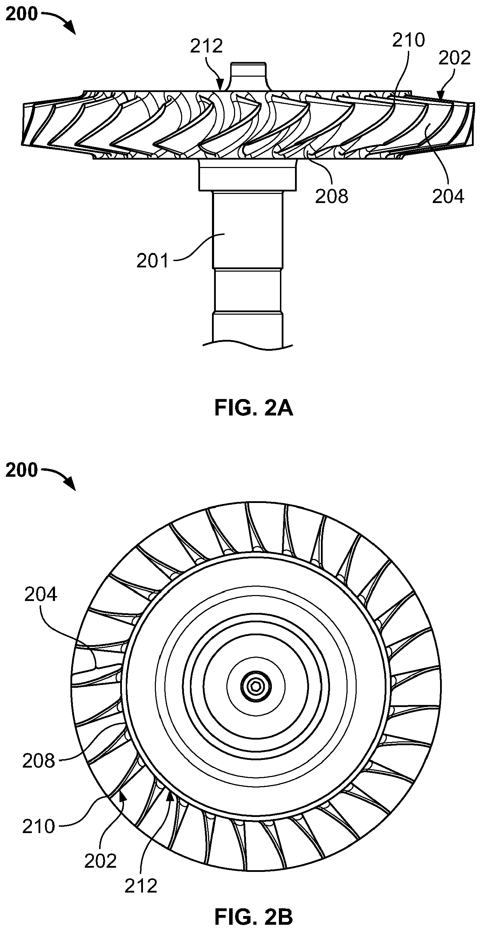

An exemplary embodiment of an air turbine starter 100 is depicted in FIG. 1, in accordance with an exemplary embodiment. In various embodiment, the air turbine starter 100 comprises a turbine wheel 102, an inlet vane 104, a diffuser 106, and an airflow exit 108. In various embodiments, an airflow 110 of air flows through the inlet vane 104 to the turbine wheel 102, and subsequently through the diffuser 106 and the airflow exit 108. In various embodiments, the turbine wheel 102 comprises an axial flow turbine wheel 102 that drives a shaft (e.g., shaft 201 depicted in FIG. 2A) for starting an engine and/or other or more other systems. In certain embodiments, the turbine wheel 102 is part of a radial inflow turbine. In certain embodiments, the air turbine starter 100 and/or turbine wheel 102 are utilized as part of and/or in conjunction with a turbine engine, such as a gas turbine engine for use in aircraft and/or other vehicles. In other embodiments, the turbine wheel 102 can be utilized in any number of other gas turbine and/or other applications.

FIGS. 2A and 2B provide partial views of a turbine rotor component 200, in accordance with an exemplary embodiment. In various embodiments, the turbine rotor component 200 can be used in number of different types of air turbine starters, such as the air turbine starter 100 of FIG. 1, among various other gas turbine applications and/or other potential applications. In certain embodiments, the turbine rotor component 200 may correspond to the turbine wheel 102 of FIG. 1.

As shown in FIGS. 2A and 2B, the turbine rotor component 200 includes a plurality of turbine blades 202, each having a respective airfoil 204. Also as depicted in FIGS. 2A and 2B, in certain embodiments the turbine blades 202 may also include blade roots 208 and/or blade tips 210 on opposing ends of the airfoils 204. Also in certain embodiments, as depicted in FIGS. 2A and 2B, the blade roots 208 may be joined together to form an inner disk 212. In certain embodiments, as shown in FIGS. 2A and 2B, the inner disk 212 is formed as a blisk, with a fully machine rotor integral hub with the blades.

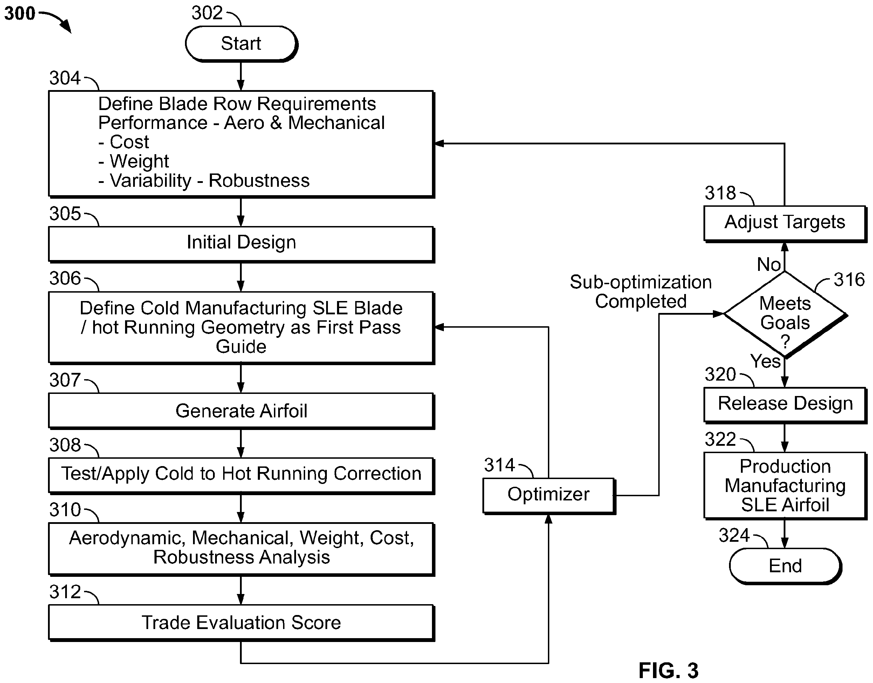

As described in greater detail below in connection with FIGS. 3-5, in various embodiments, each of the airfoils 204 is manufactured using straight line element (SLE) cuts from a cutting device in a single pass in accordance with a design that is optimized with respect to various parameters that include aerodynamic and mechanical performance as well as cost, in accordance with the process 300 described below in connection with FIG. 3.

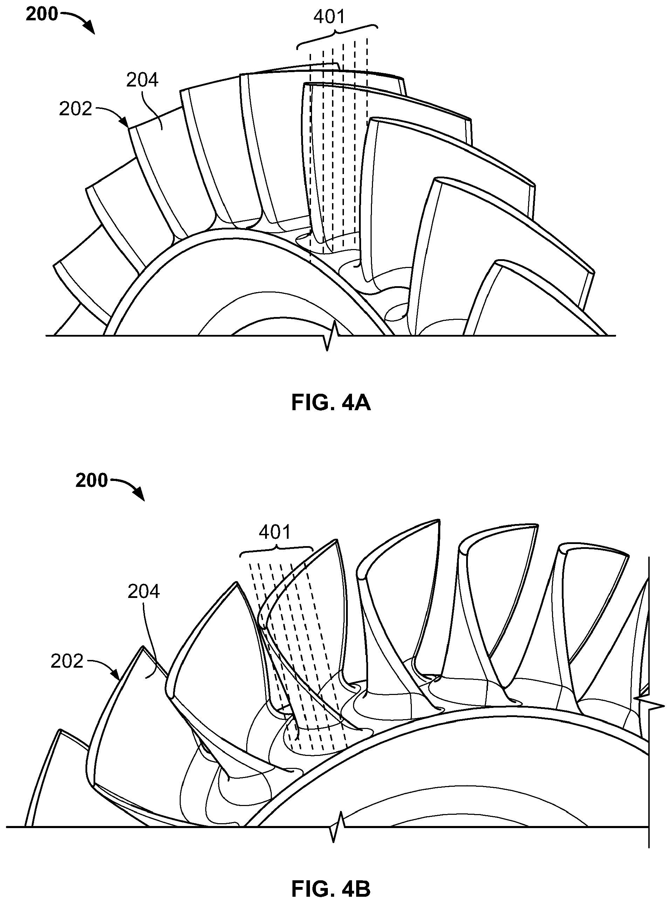

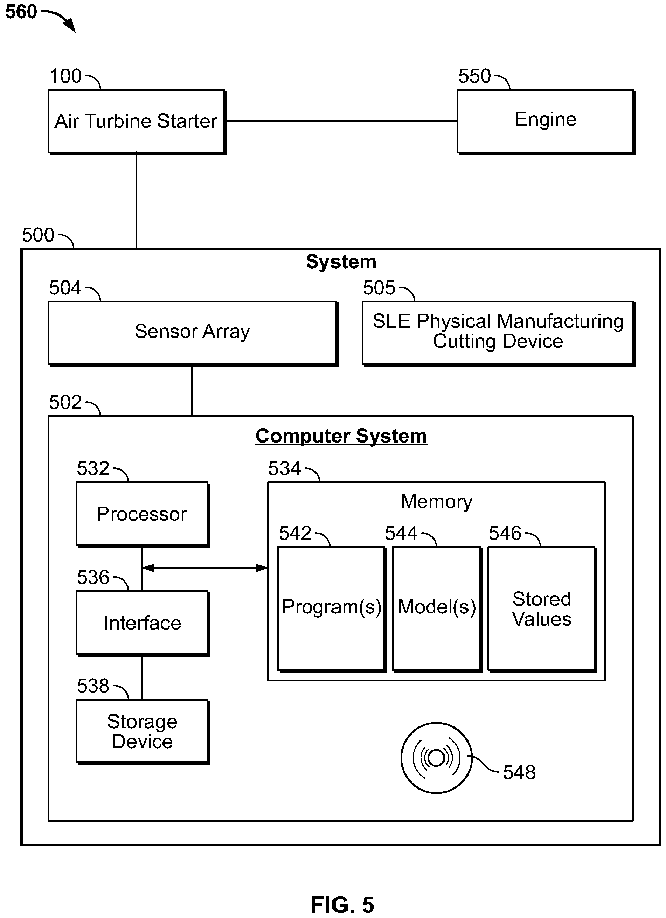

FIG. 3 is a flowchart of a process 300 that may be used to design and manufacture airfoils of an air turbine starter, in accordance with an exemplary embodiment. In various embodiments, the process 300 may be implemented in connection with a manufacturing design for the airfoils 204 of the turbine rotor component 200 of FIGS. 2A and 2B. In addition, the process 300 is also described below with reference to (i) FIGS. 4A and 4B (which depict surfaces used for manufacturing turbine airfoils using straight lines cuts in accordance with the process 300 of FIG. 3); and (ii) FIG. 5 (which depicts a system 500 for executing the process 300 of FIG. 3).

As depicted in FIG. 3, in various embodiments the process 300 begins at step 302, as a new design is desired or requested for a turbine airfoil. In certain embodiments, the steps of the process 300 are performed continuously beginning with step 302.

During step 304, blade row requirements are defined. In various embodiments, requirements are defined with respect to the turbine blades 202 of FIGS. 2A and 2B. In certain embodiments, the blade row requirements are defined with respect to the airfoils 204 of the turbine blades 202. In various embodiments, the blade row requirements pertain to aerodynamic and mechanical performance of an engine (e.g., a turbine engine) in which the turbine blades 202 are utilized. Also in certain embodiments, the blade row requirements may also pertain to manufacturing cost, weight, variability, and/or robustness (e.g., manufacturing tolerances) for the engine. For example, in certain embodiments, aerodynamic requirements and/or factors may include rotational speed, flow capacity, pressure drop, work extraction, efficiency, and/or other parameters for the engine. Also in certain embodiments, mechanical performance requirements and/or factors may include stress, vibratory margin, life, crack growth limit, and/or other parameters for the engine. In various other embodiments, requirement may also pertain to peak stress, stress balance, peak stress location, vibratory frequency margin, fatigue life, FOD tolerance, weight, and/or any of a number of other parameters. In various embodiments, the blade requirements are defined by a processor (such as the processor 532 depicted in FIG. 5 and described further below) and stored in a memory as stored values thereof (such as the stored values 546 of the memory 534 depicted in FIG. 5 and described further below).

In various embodiments, an initial design is defined at 305 for the turbine airfoils. In various embodiments, the initial design comprises an initial design for manufacturing the turbine airfoils using straight line cuts. In certain embodiments, the initial design can be formed using basic functional requirements evaluated with a preliminary design tool that provides certain performance characteristics, such as rotational speed, flow capacity, work, pressure drop, inlet and outlet air angles, and expected efficiency. In certain embodiments, this includes a flowpath with hub and shroud and initial leading edge and trailing edge positions. Also in certain embodiments, this flowpath geometry and air angles is turned into the initial blade shape. In certain other examples, the initial design may comprise a prior design to be used as a starting point in the current design, and/or an initial design intended to maximize one of the parameters noted above (e.g., aerodynamic or mechanical performance), among other possible starting points for the design. In various embodiments, the initial design is defined by a processor (such as the processor 532 depicted in FIG. 5).

In various embodiments, the initial design (as well as subsequent designs considered and/or selected in the process 300 of FIG. 3) includes a particular line of cutting (e.g., including a particular cutting starting point and direction of cutting) of the turbine airfoil using straight line element (SLE) cuts from a drill, blade, and/or other cutting device (e.g., cutting device 505 depicted in FIG. 5 and described further below) in a single pass. As will be explained in greater detail further below, the initial design will be tested and analyzed, along with other possible designs, in determining an optimized design for manufacturing the turbine airfoils using the SLE cuts.

With reference to FIGS. 4A and 4B, views are depicted of surfaces of the turbine rotor component 200 of FIGS. 2A and 2B, depicted with straight line element (SLE) cut lines 401 illustrated on a representative blade 202 of each of the surfaces for manufacturing in accordance with the process 300 of FIG. 3, in accordance with an exemplary embodiment. Specifically, as depicted in various embodiments, the various designs of the process 300 of FIG. 3 include straight line element cuts along cut lines 401 that are implemented from the leading to the trailing edge of the airfoil. Specifically, in various embodiments, FIGS. 4A and 4B illustrate the straight line element cutter orientation on the airfoil surface 204, with a number of SLE cuts along lines 401 for the airfoils 204. In certain embodiments, the cutter lines 401 for the SLE cuts may line up with the leading edge or trailing edge. In certain other embodiments, the cutter lines 401 for the SLE cuts may run 'off' the edge and only partially laying on the surface, while the blade still has SLE definition on all parts of the surfaces. In addition, in certain embodiments, there is no point on the airfoil that is not defined by one of the straight line element cutting lines 401.

Specifically, in certain embodiments, the airfoil is one hundred percent (100%) defined by the SLE cut lines 401. In certain other embodiments, the airfoil may be partially defined by the SLE cut lines 401. For example, in certain embodiments, the airfoil may be defined at least fifty percent (50%) by the SLE cut lines 401. In certain embodiments, the airfoil may be defined at least twenty five percent (25%) by the SLE cut lines 401. It will be appreciated that the percentage may vary in different embodiments.

With reference back to FIG. 3, at step 306, manufacturing techniques are defined for the initial design. In various embodiments, a sequence of straight lines elements cuts is defined for manufacturing the turbine airfoils in accordance with the initial design. In certain embodiments, a processor (such as the processor 532 of FIG. 5) defines the straight line elements cuts for a cutting blade for manufacturing turbine airfoils in connection with the initial design.

Turbine airfoils are then generated (either virtually or physically) in accordance with the initial design at step 307. In certain embodiments, virtual cuts are made using a computer model (e.g., corresponding to the model 544 of FIG. 5) in order to obtain results via the computer model for analysis via a processor (such as the processor 542 of FIG. 5). Alternatively, in certain other embodiments, physical cuts are made via a physical blade in order to physically generate turbine airfoils for physical testing and analysis (e.g., via the sensor array 504 and the processor 542 of FIG. 5).

Testing is performed at step 308 with respect to the airfoils. In certain embodiments in which virtual cuts were made using a computer model, then computer model is then used to run various tests on the resulting turbine engine, with results generated by the computer model 544 of FIG. 5. Conversely, in certain other embodiments in which physical cuts were made using a physical blade, physical tests are run on the resulting turbine engine, with readings recorded by the sensor array 504 of FIG. 5. In various embodiments, the virtual and/or physical testing of the air turbine starter (and/or a turbine engine and/or other device in which the air turbine starter may be utilized).

Analysis is performed at step 310 with respect to various parameters. In various embodiments, analysis is performed by the processor 532 of FIG. 5 with respect to aerodynamic, mechanical, weight, and robustness parameters (and, in certain embodiments, engine weight) of the air turbine starter (and/or an engine and/or other device in which the air turbine starter is utilized) based on the virtual or physical data collected for the initial design in step 308. In various embodiments, the processor 532 of FIG. 5 calculates an evaluation score for the particular design at step 312, that is based on the analysis.

In addition, in various embodiments, the processor 532 utilizes the calculated score of the current design (along with respective scores of other possible designs) in an optimizer during step 314, in order to arrive at a preliminary optimized design. In certain embodiments, the preliminary optimized design is determined by the processor 532 by optimizing a weighted score that provides different weights for the different variables. In certain embodiments, this sorting and/or weighting is performed based weighting each of the metrics based on customer input and product requirements. Also in certain embodiments, the weighted score is a weighted average of how close or above (fractionally or in percentage terms) each quality parameter is to the design goal.

In various embodiments, steps 306-314 repeat with various possible different airfoil designs, for example with different cutting starting points and/or different directions of cutting for the straight line cuts. Also in various embodiments, as testing and analysis is performed for each of the designs, respective scores are calculated for each of the designs. In various embodiments, the design with the highest score is determined to be the preliminary optimized design during step 314. At this point, the sub-optimization is deemed to be complete by the processor 532 of FIG. 5.

A determination is then made during step 316 as to whether the preliminary optimized design meets any predefined requirements and/or goals for the engine parameters. In certain embodiments, during step 316, the processor 532 of FIG. 5 determines whether the preliminary optimized design meets any particular requirements (e.g., regulatory and/or other baseline requirements) as to aerodynamic performance and/or mechanical performance (e.g., that may be stored in the computer memory 534 of FIG. 5 as stored values 546 thereof).

If it is determined at 316 that the preliminary optimized design does not meet one or more parameter requirements, then the process proceeds to step 318. During step 318, adjustments are made to weighting criteria for the engine parameters used for calculated the design score. In various embodiments, these adjustments are made by the processor 532 of FIG. 5, for example, in providing relatively greater weights to parameters whose requirements were not met by the preliminary optimized design. The process returns to step 304, and steps 304-316 thereafter repeat using the updated weighting for the design score, until a determination is made during an iteration of step 316 that all requirements and/or goals for the engine parameters have been met.

Once a determination is made during an iteration of step 316 that all requirements and/or goals for the engine parameters have been met, then the preliminary optimized design of the current iteration (i.e., of the most recent iteration of step 314) is deemed to be the final optimized design at step 320. In various embodiments, this is performed by the processor 532 of FIG. 5, and the final optimized design is released.

Also in various embodiments, the final optimized design is utilized in step 322 in manufacturing the airfoils. In various embodiments, a processor (e.g., the processor 532 of FIG. 1) provides instructions for a cutting apparatus (e.g., the cutting device 505 of FIG. 5) to manufacture the turbine airfoils via straight line cuts in implementing the final optimized design of step 320. In various embodiments, the process then terminates at step 324.

Accordingly, in various embodiments, the process 300 of FIG. 3 provides an optimized design for manufacturing a turbine airfoil using straight line elements (SLE) cuts, while maximizing a score in which a number of parameters (such as aerodynamic performance, mechanical performance, cost, and engine weight) are weighted together. In certain embodiments, the final optimized design may comprise a design that minimizes manufacturing cost, and/or one or more other parameters (e.g., engine size and/or weight) while still meeting baseline standards for aerodynamic and mechanical performance. In various embodiments, different other respective weights may be provided for the various parameters, and so on. Also in various embodiments, the process 300 is utilized in connection with an air turbine starter; however, this may vary in other embodiments.

As alluded to above, FIG. 5 is a functional block diagram of a system 500 for designing and manufacturing of turbine airfoils in accordance with the process 300 of FIG. 3, in accordance with an exemplary embodiment. As depicted in FIG. 5, in various embodiments the system 500 includes a computer system 502. In certain embodiments, the system 500 also includes a sensor array 504 and a cutting device 505, among other possible components.

As depicted in FIG. 5, the computer system 502 includes a processor 532, a memory 534, an interface 536, a storage device 538, a bus 540, and a disk 548.

As depicted in FIG 5, the computer system 502 comprises a computer system. In certain embodiments, the computer system 502 may also include the above-referenced sensor array 504 and/or one or more other components. In addition, it will be appreciated that the computer system 502 may otherwise differ from the embodiment depicted in FIG 5. For example, the computer system 502 may be coupled to or may otherwise utilize one or more remote computer systems and/or other control systems, for example as part of one or more of the above-identified vehicle devices and systems.

In the depicted embodiment, the computer system 502 includes a processor 532, a memory 534, an interface 536, a storage device 538, and a bus 540. The processor 532 performs the computation and control functions of the computer system 502, and may comprise any type of processor or multiple processors, single integrated circuits such as a microprocessor, or any suitable number of integrated circuit devices and/or circuit boards working in cooperation to accomplish the functions of a processing unit. During operation, the processor 532 executes one or more programs 542 contained within the memory 534 and, as such, controls the general operation of the computer system 502, generally in executing the processes described herein, such as the process 300 discussed above in connection with FIG. 3.

The memory 534 can be any type of suitable memory. For example, the memory 534 may include various types of dynamic random access memory (DRAM) such as SDRAM, the various types of static RAM (SRAM), and the various types of non-volatile memory (PROM, EPROM, and flash). In certain examples, the memory 534 is located on and/or co-located on the same computer chip as the processor 532. In the depicted embodiment, the memory 534 stores the above-referenced program 542 along with one or more turbine models 544 and stored values 546 (e.g., for analyzing turbine engine performance among different design iterations, and comparing performance values against predetermined thresholds, and so on), in accordance with the process 300 depicted in FIG. 3, and described in greater detail above.

The bus 540 serves to transmit programs, data, status and other information or signals between the various components of the computer system 502. The interface 536 allows communications to the computer system 502, for example from a turbine engine designer and/or from another computer system, and can be implemented using any suitable method and apparatus. The interface 536 can include one or more network interfaces to communicate with other systems or components. The interface 536 may also include one or more network interfaces to communicate with technicians, and/or one or more storage interfaces to connect to storage apparatuses, such as the storage device 538.

The storage device 538 can be any suitable type of storage apparatus, including various different types of direct access storage and/or other memory devices. In one exemplary embodiment, the storage device 538 comprises a program product from which memory 534 can receive a program 542 that executes one or more embodiments of one or more processes of the present disclosure, such as the steps of the process 300 discussed further below in connection with FIG. 3. In another exemplary embodiment, the program product may be directly stored in and/or otherwise accessed by the memory 534 and/or one or more other disks 548 and/or other memory devices.

The bus 540 can be any suitable physical or logical means of connecting computer systems and components. This includes, but is not limited to, direct hard-wired connections, fiber optics, infrared and wireless bus technologies. During operation, the program 542 is stored in the memory 534 and executed by the processor 532.

It will be appreciated that while this exemplary embodiment is described in the context of a fully functioning computer system, those skilled in the art will recognize that the mechanisms of the present disclosure are capable of being distributed as a program product with one or more types of non-transitory computer-readable signal bearing media used to store the program and the instructions thereof and carry out the distribution thereof, such as a non-transitory computer readable medium bearing the program and containing computer instructions stored therein for causing a computer processor (such as the processor 532) to perform and execute the program. Such a program product may take a variety of forms, and the present disclosure applies equally regardless of the particular type of computer-readable signal bearing media used to carry out the distribution. Examples of signal bearing media include: recordable media such as floppy disks, hard drives, memory cards and optical disks, and transmission media such as digital and analog communication links. It will be appreciated that cloud-based storage and/or other techniques may also be utilized in certain embodiments. It will similarly be appreciated that the computer system 502 may also otherwise differ from the embodiment depicted in FIG 5, for example in that the computer system 502 may be coupled to or may otherwise utilize one or more remote computer systems and/or other control systems.

In various embodiments, the sensor array 504 comprises any number of sensors that may be utilized in performing the testing of step 308, in embodiments in which physical cutting and testing of the airfoils is performed during steps 307 and 308. Also in various embodiments, the cutting device 505 includes one or more drills, cutting blades, and/or other cutting devices that are used to physically manufacture the turbine airfoils using straight line cuts, including in the implementation of the final optimized design in step 322 (and in certain embodiments, also for the physical cutting of turbine airfoils of the different potential designs in step 307 for testing in step 308. In certain embodiments, the SLE cuts could be made on a five axis milling machine with tapered or shaped cutters; however, this may vary in other embodiments.

Also as depicted in FIG. 5, in certain embodiments, the air turbine starter 100 may be part of and/or coupled to one or more engines 550, for example a gas turbine engine used for aircraft and/or other vehicles and/or other systems in various embodiments. In various embodiments, the air turbine starter 100 is configured to start the engine 550. In certain embodiments, one or more of the air turbine starter 100, engine 550, and/or system 500 may collectively comprise and/or be referred to as system 560.

Accordingly, methods and systems are provided for generating a design for manufacturing airfoils for turbine engines using straight line cuts in accordance with a design that is optimized to minimize costs while meeting aerodynamic and mechanical requirements.

It will be appreciated that the methods and systems may vary from those depicted in the Figures and described herein. For example, it will be appreciated that the steps of the process 300 may differ, and/or that various steps thereof may be performed simultaneously and/or in a different order, than those depicted in FIG. 3 and/or described above. It will likewise be appreciated that the vehicles, turbines, airfoils, computer system, components thereof, and/or implementations may also differ from those depicted in FIGS. 1-5 and/or described above.

Moreover, the various illustrative logical blocks, modules, and circuits described in connection with the embodiments disclosed herein may be implemented or performed with a general purpose processor, a digital signal processor (DSP), an application specific integrated circuit (ASIC), a field programmable gate array (FPGA) or other programmable logic device, discrete gate or transistor logic, discrete hardware components, or any combination thereof designed to perform the functions described herein. A general-purpose processor may be a microprocessor, but in the alternative, the processor may be any conventional processor, controller, microcontroller, or state machine. A processor may also be implemented as a combination of computing devices, e.g., a combination of a DSP and a microprocessor, a plurality of microprocessors, one or more microprocessors in conjunction with a DSP core, or any other such configuration.

The steps of a method or algorithm described in connection with the embodiments disclosed herein may be embodied directly in hardware, in a software module executed by a processor, or in a combination of the two. A software module may reside in RAM memory, flash memory, ROM memory, EPROM memory, EEPROM memory, registers, hard disk, a removable disk, a CD-ROM, or any other form of storage medium known in the art. An exemplary storage medium is coupled to the processor such that the processor can read information from, and write information to, the storage medium. In the alternative, the storage medium may be integral to the processor. The processor and the storage medium may reside in an ASIC. The ASIC may reside in a user terminal. In the alternative, the processor and the storage medium may reside as discrete components in a user terminal.

In this document, relational terms such as first and second, and the like may be used solely to distinguish one entity or action from another entity or action without necessarily requiring or implying any actual such relationship or order between such entities or actions. Numerical ordinals such as "first," "second," "third," etc. simply denote different singles of a plurality and do not imply any order or sequence unless specifically defined by the claim language. The sequence of the text in any of the claims does not imply that process steps must be performed in a temporal or logical order according to such sequence unless it is specifically defined by the language of the claim. The process steps may be interchanged in any order without departing from the scope of the invention as long as such an interchange does not contradict the claim language and is not logically nonsensical.

Furthermore, depending on the context, words such as "connect" or "coupled to" used in describing a relationship between different elements do not imply that a direct physical connection must be made between these elements. For example, two elements may be connected to each other physically, electronically, logically, or in any other manner, through one or more additional elements.

While at least one exemplary embodiment has been presented in the foregoing detailed description, it should be appreciated that a vast number of variations exist. It should also be appreciated that the exemplary embodiment or exemplary embodiments are only examples, and are not intended to limit the scope, applicability, or configuration of the disclosure in any way. Rather, the foregoing detailed description will provide those skilled in the art with a convenient road map for implementing the exemplary embodiment or exemplary embodiments. It should be understood that various changes can be made in the function and arrangement of elements without departing from the scope of the disclosure as set forth in the appended claims and the legal equivalents thereof.

## Claims

1. A method for manufacturing a plurality of airfoils for a turbine wheel, the method comprising:
defining an initial design comprising an initial respective line for a straight line cut for a respective surface of each airfoil of the plurality of airfoils;
evaluating an initial score for the initial design based on mechanical, aerodynamic, manufacturing cost, and robustness criteria;
performing, in an iterative manner, a sequence of changes to the initial design, by adjusting the initial respective line for the straight line cut for the respective surface of each of the plurality of airfoils to generate different iterative designs;
evaluating respective scores for each of the different iterative designs;
selecting a design from the initial design and the different iterative designs that generates an optimized score based on the mechanical, aerodynamic, manufacturing cost, and robustness criteria; and
cutting along the straight line for the surface of each of the plurality of airfoils based on the selected design, to form each of the plurality of airfoils.

2. The method of Claim 1, wherein the selecting of the design comprises selecting a cutting starting point and a direction of cutting for the line of straight line elements cutting from the initial design and the different iterative designs that generates an optimized score based on the mechanical, aerodynamic, manufacturing cost, and robustness criteria.

3. The method of Claim 1, further comprising:
performing virtual tests, using a computer model, with respect to the initial design and the different iterative designs with respect to the mechanical, aerodynamic, manufacturing cost, and robustness criteria;
wherein the respective scores are calculated based on results from the computer model from the performing of the virtual tests.

4. The method of Claim 1, further comprising:
performing physical tests with respect to the initial design and the different iterative designs with respect to the mechanical, aerodynamic, manufacturing cost, and robustness criteria;
wherein the respective scores are calculated based on sensor data from the performing of the physical tests.

5. The method of Claim 1, wherein the step of selecting the design comprises:
determining an initial optimized design that optimizes a weighted score of the cost, robustness criteria, mechanical and aerodynamic performance criteria; and
selecting the initial optimized design as a final optimized design on a further condition that predetermined requirements of one or more parameters are satisfied by the initial optimized design.

6. The method of Claim 1, wherein the step of selecting the design comprises:
selecting the design that minimizes manufacturing cost, provided that predetermined thresholds for mechanical and aerodynamic performance are satisfied.

7. The method of Claim 1, wherein each of the plurality of airfoils is one hundred percent defined by the straight line cuts.

8. The method of Claim 1, wherein each of the plurality of airfoils is at least fifty percent defined by the straight line cuts.

9. The method of Claim 1, wherein each of the plurality of airfoils is at least twenty five percent defined by the straight line cuts.

10. A computer system for determining a design for manufacturing of a plurality of airfoils for a turbine wheel, the computer system comprising:
a non-transitory computer readable storage medium configured to store data pertaining to a plurality of potential designs for a straight line cut for a respective surface of each airfoil of the plurality of airfoils; and
a processor that is coupled to the non-transitory computer readable storage medium and configured to:
provide instructions for performing a test of each of the potential designs;
calculate a respective score for each of the potential designs, based on the testing, and based on mechanical, aerodynamic, manufacturing cost, and robustness criteria; and
select a design from the potential designs that generates an optimized score based on the mechanical, aerodynamic, manufacturing cost, and robustness criteria.

11. The system of Claim 10, wherein the processor is configured to select a cutting starting point and a cutting direction for the line of straight line elements cutting from the potential designs that generates an optimized score based on the mechanical, aerodynamic, manufacturing cost, and robustness criteria.

12. The system of Claim 10, wherein the processor is configured to:
provide instructions for performing a virtual test of each of the potential designs using a computer model; and
calculate a respective score for each of the potential designs, based on the results from the computer model from the virtual tests.

13. The system of Claim 10, wherein the processor is configured to:
provide instructions for performing physical tests of each of the potential designs; and
calculate a respective score for each of the potential designs, based on sensor data from the physical tests.

14. The system of Claim 10, wherein the processor is configured to:
determine an initial optimized design that optimizes a weighted score of the cost, robustness criteria, mechanical and aerodynamic performance criteria; and
select the initial optimized design as a final optimized design on a further condition that predetermined requirements of one or more parameters are satisfied by the initial optimized design.

15. The system of Claim 10, wherein the processor is configured to select the design that minimizes manufacturing cost, provided that predetermined thresholds for mechanical and aerodynamic performance are satisfied.
